# EUROPEAN PATENT APPLICATION

(11) **EP 2 642 196 A1**
(43) Date of publication of application: **25.09.2013**
(21) Application number: 12173788.6
(22) Date of filing: 27.06.2012
(51) Int. Cl.: F21V 29/00, F21K 99/00, F21V 15/01, F21V 23/00, H05K 1/02

(54) **Luminaire and method of thermal radiation of the luminaire**

(30) Priority: 22.03.2012 JP 2012066217
(71) Applicant: Toshiba Lighting & Technology Corporation, Yokosuka-shi Kanagawa 237-8510 (JP)
(72) Inventor: Nezu, Kenji, Kanagawa, 237-8510 (JP); Matsumoto, Shinichiro, Kanagawa, 237-8510 (JP)
(74) Representative: Bokinge, Ole

(57) **Abstract**

According to one embodiment, a luminaire includes: a light-emitting portion (20) having a light-emitting element; a circuit board (30) having a notch (31) or a through hole (32); an electronic component (40) mounted on a side of a second main surface (30b) opposite to a first main surface (30a) of the circuit board (30); a thermal radiator (10) provided on a side of the first main surface (30a) and including the light-emitting portion (20) disposed on the thermal radiator (10); a thermally-conductive medium (50) disposed on the side of the first main surface (30a) of the circuit board (30) and being in contact with the electronic component (40) through the notch (31) or the through hole (32), and capable of transferring heat generated by the electronic component (40) to the side of the first main surface (30a) of the circuit board (30); and an outer frame member (60) accommodating the light-emitting portion (20), the circuit board (30), the electronic component (40), and the thermally-conductive medium (50).

## Description

### FIELD

Embodiments described herein relates generally to a luminaire and a method of thermal radiation of the luminaire.

### BACKGROUND

As a method of thermal radiation of electronic components mounted on a circuit board in luminaires having light-emitting elements such as LEDs (Light Emitting Diodes) as light sources, for example, LED light bulbs or LED units, there is a method of covering the electronic components directly with a thermally-conductive medium. However, with the method of covering the electronic components with the thermally-conductive medium, a thermal radiation effect of the electronic components is low, and hence effective thermal radiation cannot be expected.

As a method of radiating heat from the electronic components mouthed on the circuit board, there is a method of embedding the electronic components mounted on the circuit board into the thermally-conductive medium on the side of a mount surface of the circuit board where the electronic components are mounted. However, with the method of embedding the electronic components mounted on the circuit board into the thermally-conductive medium on the side of the mount surface of the circuit board where the electronic components are mounted, nothing more than radiating the heat generated by the electronic components on the side of the mount surface is performed. In addition, in this method, the amount of usage of the thermally-conductive medium is increased, and hence increase in cost is resulted.

### BRIEF DESCRIPTION OF THE DRAWINGS

Fig. 1A is a schematic cross-sectional view of an entire luminaire according to a first embodiment;
Fig. 1B is an enlarged schematic cross-sectional view of a portion around a thermally-conductive medium of the luminaire according to the first embodiment;
Fig. 2A is a schematic plan view of a circuit board according to the first embodiment;
Fig. 2B is a perspective schematic drawing of the circuit board according to the first embodiment;
Fig. 3 is a schematic cross-sectional view for explaining an operation of the luminaire according to the first embodiment;
Fig. 4 is a schematic cross-sectional view of the luminaire according to a second embodiment;
Fig. 5 is a schematic cross-sectional view of the luminaire according to a first example of a third embodiment;
Fig. 6 is a schematic cross-sectional view of the luminaire according to a second example of the third embodiment;
Fig. 7 is a schematic cross-sectional view of the luminaire according to a fourth embodiment;
Fig. 8 is a schematic cross-sectional view of the luminaire according to a fifth embodiment;
Fig. 9 is a schematic cross-sectional view of the luminaire according to a sixth embodiment;
Fig. 10 is a schematic cross-sectional view of the luminaire according to a seventh embodiment; and
Fig. 11 is a schematic partial cross-sectional view of the luminaire according to an eighth embodiment.

### DETAILED DESCRIPTION

In general, according to one embodiment, a luminaire includes: a light-emitting portion having a light-emitting element; a circuit board having a notch or a through hole; an electronic component mounted on a side of a second main surface opposite to a first main surface of the circuit board; a thermal radiator provided on a side of the first main surface and including the light-emitting portion disposed on the thermal radiator; a thermally-conductive medium disposed on the side of the first main surface of the circuit board and being in contact with the electronic component through the notch or the through hole, and capable of transferring heat generated by the electronic component to the side of the first main surface of the circuit board; and an outer frame member accommodating the light-emitting portion, the circuit board, the electronic component, and the thermally-conductive medium.

Referring now to the drawings, embodiments will be described. In the following description, the same members are designated by the same reference numerals, and description of the members described once will be omitted as needed.

### (First Embodiment)

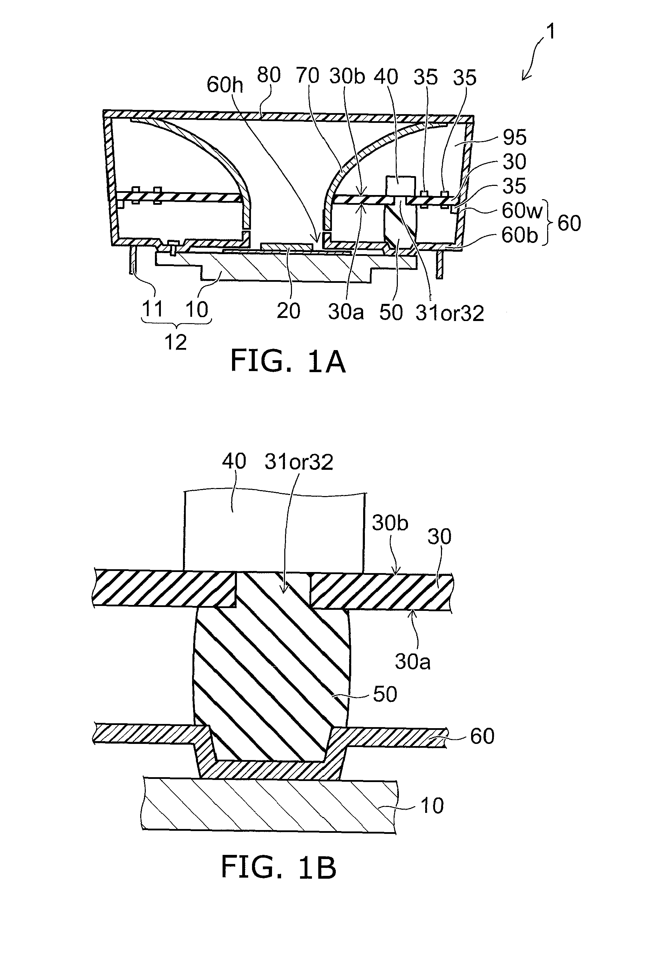

Fig. 1A is a schematic cross-sectional view of an entire luminaire according to a first embodiment, and Fig. 1B is an enlarged schematic cross-sectional view of a portion around a thermally-conductive medium of the luminaire according to the first embodiment.

A luminaire 1 according to the first embodiment is a luminaire having a standardized cap such as GX53 or GH76p.

The luminaire 1 includes a light-emitting portion 20, a circuit board 30 having a notch 31 or a through hole 32, an electronic component 40 mounted on a side of a second main surface 30b opposite to a first main surface 30a of the circuit board 30, a thermal radiator 10 provided on a side of the first main surface 30a and including the light-emitting portion 20 disposed on the thermal radiator 10, a thermally-conductive medium 50 provided in the notch 31 or the through hole 32 from the side of the first main surface 30a of the circuit board 30 and coming into contact with the electronic component 40, and an outer frame member 60 configured to accommodate the light-emitting portion 20, the circuit board 30, the electronic component 40, and the thermally-conductive medium 50. Heat generated by the electronic component 40 is allowed to be transferred to the side of the first main surface 30a of the circuit board 30 via the thermally-conductive medium 50.

The configuration of the luminaire 1 will be described further in detail. The luminaire 1 includes the thermal radiator 10 formed of a metal (for example, aluminum (Al)), the light-emitting portion 20 mounted on the thermal radiator 10, and the circuit board 30 above the thermal radiator 10 at a predetermined distance from the thermal radiator 10 and the light-emitting portion 20, that is, on a side of a light-emitting of the light-emitting portion 20. The light-emitting portion 20 includes light-emitting elements. The light-emitting portion 20 includes a plurality of light-emitting elements such as LEDs (Light Emitting Diodes) which are arranged. The circuit board 30 includes the notch 31 or the through hole 32 at a mount position (for example, immediately below) of the electronic component 40.

The luminaire according to the first embodiment is not limited to those employing the LEDs as the light-emitting elements. For example, luminaires employing light-emitting elements such as EL (Electro-Luminescence) or organic light-emitting diodes (OLEDs) as the light-emitting elements instead of the LEDs are also included in the scope of the first embodiment.

The luminaire 1 also includes the electronic component 40. Assuming that the main surface of the circuit board 30 opposing the thermal radiator 10 is first main surface 30a and the main surface of the circuit board 30 opposite to the first main surface 30a is a second main surface 30b, the electronic component 40 is mounted on the second main surface 30b. Circuit patterns 35, formed of a metal (for example, copper (Cu)), are formed on the first main surface 30a and the second main surface 30b of the circuit board 30. Examples of the electronic component 40 include a coil, a transformer, a diode, a transistor, a resistance, or a capacitor. In Fig. 1A, only one of the electronic components 40 is illustrated. However, the number of the electronic components 40 is not limited to one.

The luminaire 1 further includes the thermally-conductive medium 50. The thermally-conductive medium 50 is provided on the side of the first main surface 30a of the circuit board 30, and is in contact with the electronic component 40 via the notch 31 or the through hole 32. The thermally-conductive medium 50 preferably has insulation properties. The thermally-conductive medium 50 is formed of a material having a coefficient of thermal conductivity higher than air. Examples of the materials of the thermally-conductive medium 50 include organic materials and inorganic materials. When resins are used as the material of the thermally-conductive medium 50, for example, resins such as silicone resin, polyimide resin, and epoxy resin may be employed.

The luminaire 1 further includes the outer frame member (housing) 60 formed of a resin. The outer frame member 60 is in contact with the thermally-conductive medium 50. The outer frame member 60 is configured to accommodate the light-emitting portion 20, the circuit board 30, the electronic component 40, and the thermally-conductive medium 50. The outer frame member 60 includes a bottom surface portion 60b and a side surface portion 60w. The bottom surface portion 60b is interposed between the thermal radiator 10 and the circuit board 30, and the bottom surface portion 60b is in contact with the thermal radiator 10. That is, part of the thermal radiator 10 is in contact with the outside of the outer frame member 60.

In other words, the thermal radiator 10 constitutes part of an outer shell of the luminaire 1. The thermal radiator 10 may further constitute part of the outer frame member 60. That is, the thermal radiator 10 is formed so as to cover an opening portion 60h which is provided so as to communicate the interior and the exterior of the outer frame member 60. In the first embodiment, the thermal radiator 10 is mounted on the bottom surface portion 60b so as to close the opening portion 60h provided at a center of the bottom surface portion 60b, so that the thermal radiator 10 constitutes part of the outer frame member 60.

In addition, the luminaire 1 includes a reflector 70, a translucent shielding member 80, and an electrode pin 11. With the provision of the reflector 70, the electronic components 40 are arranged in a space 95 surrounded by the circuit board 30, the outer frame member 60, and the reflector 70. The translucent shielding member 80 is provided so as to cover the reflector 70 and the light-emitting portion 20. The translucent shielding member 80 allows passage of light emitted from the light-emitting portion 20 and simultaneously protects the light-emitting portion 20. The electrode pin 11 functions as an electrode for supplying electric power to the electronic component 40, or an electrode for supplying a light-modulating signal, or a grounding electrode. The electrode pin 11 and the thermal radiator 10 may be collectively referred to as a cap 12.

When the luminaire 1 is viewed in the direction perpendicular to the main surfaces (the first main surface 30a or the second main surface 30b) of the circuit board 30, the outline of the light-emitting portion 20 has a rectangular shape, and the outline of the thermal radiator 10 and the outline of the circuit board 30 have approximately a circular shape. The outer diameter of the light-emitting portion 20 is smaller than the outer diameter of the thermal radiator 10 and the outer diameter of the circuit board 30. The outer diameter of the thermal radiator 10 is smaller than the diameter of the circuit board 30.

In Fig. 1, a state in which the translucent shielding member 80 side is located on the upper side, and the thermal radiator 10 side is located on the lower side is illustrated. However, the position in which the translucent shielding member 80 side is located on the lower side, and the thermal radiator 10 side is located on the upper side is also applicable.

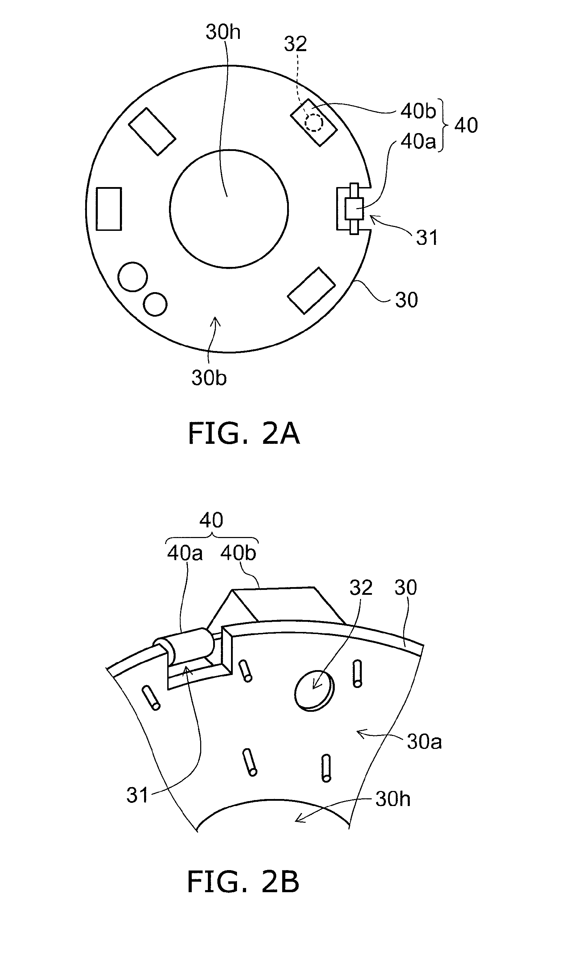

Fig. 2A is a schematic plan view of the circuit board according to the first embodiment, and Fig. 2B is a perspective schematic drawing of the circuit board according to the first embodiment.

Illustrated in Fig. 2A is the side of the second main surface 30b of the circuit board 30, and illustrated in Fig. 2B is the side of the first main surface 30a of the circuit board 30.

The outline of the circuit board 30 has a circular shape and includes a hollow portion 30h at a center of the circuit board 30. In other words, the circuit board 30 has an annular shape. A plurality of electronic components 40 (the electronic components 40a and 40b) are provided on the second main surface 30b of the circuit board 30 . Here, assuming that the side of the second main surface 30b is an upper side and the side of the first main surface 30a is a lower side, the notch 31 is provided under the electronic component 40a in the circuit board 30, and the through hole 32 is provided under the electronic component 40b in the circuit board 30. When the circuit board 30 is integrated in the luminaire, the light-emitting portion 20 is located under the hollow portion 30h of the circuit board 30.

In the luminaire 1, when the light-emitting portion 20 is caused to emit light, the light emitted from the light-emitting portion 20 reaches the translucent shielding member 80 or the reflector 70. The light directly reaching the translucent shielding member 80 is radiated from the translucent shielding member 80 to the outside of the luminaire 1. The light reaching the reflector 70 is also reflected by the reflector 70, reaches the translucent shielding member 80 in time, and is radiated from the translucent shielding member 80 to the outside of the luminaire 1.

Here, the annular circuit board 30 is arranged on the outside of the light-emitting portion 20 and is arranged in a space surrounded by the bottom surface portion 60b and the side surface portion 60w of the outer frame member 60 and the reflector 70. Since the more the light-emitting portion 20 comes close to the thermal radiator 10, the more thermal radiating efficiency of the light-emitting portion 20 increases, the light-emitting portion 20 in the first embodiment is disposed on the thermal radiator 10, which is arranged on the lower most side to the light-emitting portion 20. The circuit board 30 is arranged on a side of the bottom surface portion 60b in order to secure flexibility of optical design of the reflector 70, and the electronic components 40 are mounted on the side of the second main surface 30b, that is, on the side where light goes out. In other words, the electronic components 40 are mounted on the surface of the circuit board 30 toward the opposite side to the direction of thermal radiation from the light-emitting portion 20 to the thermal radiator 10. In the first embodiment, in this manner, a thermal radiation route from the electronic component 40 toward the thermal radiator 10 can be formed, concerning the luminaire that the electronic components 40 is mounted on the surface of the circuit board 30 toward the opposite side to the direction of a thermal radiation route of the light-emitting portion 20.

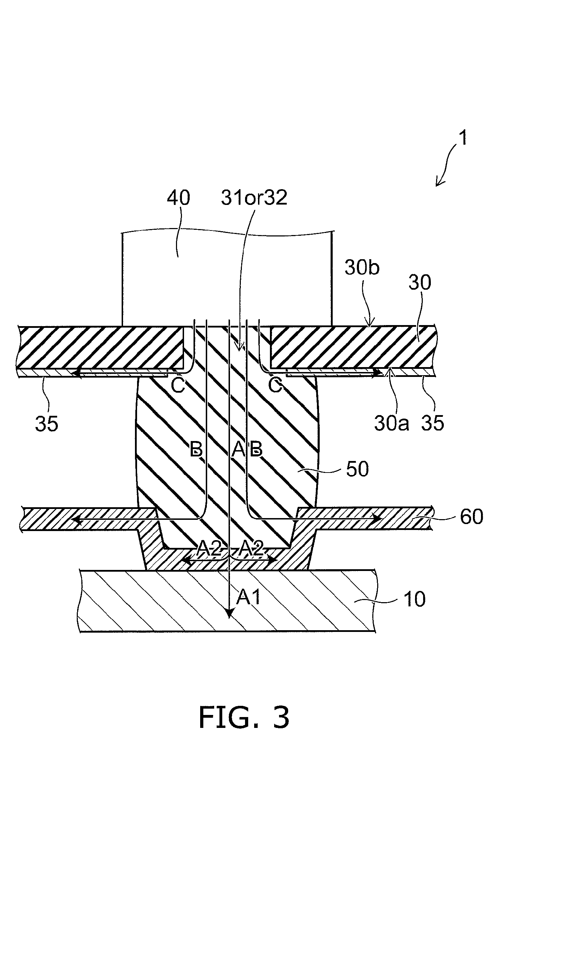

Fig. 3 is a schematic cross-sectional view for explaining an operation of the luminaire according to the first embodiment.

Fig. 3 illustrates a state in which the thermally-conductive medium 50 is in contact with the outer frame member 60, and the first main surface 30a of the circuit board 30.

In order to cause the light-emitting portion 20 to emit light, driving of the electronic components 40 is necessary. When the electronic components 40 are driven, the electronic components 40 may generate heat. In order to elongate the lifetime of the luminaire or to avoid deterioration of characteristics, the heat generated by the electronic components 40 is preferably radiated to the outside of the luminaire 1 as much as possible.

In the luminaire 1, the heat generated by the electronic components 40 is radiated from the side of the second main surface 30b to the side of the first main surface 30a of the circuit board 30 via the thermally-conductive medium 50 disposed in the notch 31 or the through hole 32 in contact with the electronic components 40.

For example, in a rout A in Fig. 3, the heat generated by the electronic components 40 is transferred from the side of the second main surface 30b to the side of the first main surface 30a of the circuit board 30 via the thermally-conductive medium 50 in contact with the electronic components 40 via the notch 31 or the through hole 32. Subsequently, the heat is transferred to a portion, which is the thermal radiator portion in contact with the outside of the outer frame member 60, via the thermally-conductive medium 50, and is radiated to the portion of the thermal radiator 10 in contact with the outside of the outer frame member 60 (arrow Al), and is also transferred to the outer frame member 60 and is radiated to the outer frame member 60 (arrow A2).

In a route B, the heat generated by the electronic components 40 is transferred from the side of the second main surface 30b to the side of the first main surface 30a of the circuit board 30 via the thermally-conductive medium 50 disposed in the notch 31 or the through hole 32 in contact with the electronic components 40. Subsequently, the heat is transferred to the outer frame member 60 via the thermally-conductive medium 50, and is radiated to the outer frame member 60.

In this manner, the heat generated by the electronic components 40 is radiated to the thermal radiator 10 or the outer frame member 60 efficiently via the thermally-conductive medium 50.

Furthermore, the circuit patterns 35 are provided also on the side of the first main surface 30a of the circuit board 30. If the thermally-conductive medium 50 and the circuit pattern 35 are in contact to each other, the heat is transferred along a route C in the drawing.

In the route C, the heat generated by the electronic components 40 is transferred from the side of the second main surface 30b to the side of the first main surface 30a of the circuit board 30 via the thermally-conductive medium 50 disposed in the notch 31 or the through hole 32. In other words, the heat generated by the electronic components 40 is radiated to the circuit pattern 35 on the side of the first main surface 30a via the thermally-conductive medium 50.

In this manner, the heat generated by the electronic components 40 is efficiently dispersed along the route A, the route B, and the route C. Consequently, the thermal radiating effect of the electronic components 40 is enhanced.

Also, the luminaire 1 does not require covering of the entire surfaces of the electronic components 40 on the side of the second main surface 30b of the circuit board 30 with the thermally-conductive medium 50, or does not require embedding the electronic components 40 into the thermally-conductive medium 50. Therefore, the amount of usage of the thermally-conductive medium 50 is significantly reduced, so that weight reduction and cost reduction of the luminaire are achieved.

In addition, with the enhancement of the thermal radiating effect of the electronic components 40, so called heat accumulation can hardly occur within the space 95 surrounded by the circuit board 30, the outer frame member 60, and the reflector 70. Accordingly, probability of occurrence of deterioration or deformation of the circuit board 30, the outer frame member 60, and the reflector 70 is reduced. Furthermore, with the enhancement of the thermal radiating effect of the electronic components 40, the lifetime of the electronic components 40 is elongated.

Since efficient radiation of the heat from the electronic components 40 is achieved, increase in temperature of the light-emitting portion 20 is inhibited. Consequently, lowering of a light-emitting efficiency of the light-emitting portion 20 is inhibited and light-emission with a high efficiency and elongation of the lifetime of the light-emitting portion 20 are also achieved.

Furthermore, with the enhancement of the light-emitting efficiency of the light-emitting portion 20, reduction in the number of the light-emitting elements such as the LEDs to be mounted on the light-emitting portion 20 is achieved. Consequently, reduction in power consumption and reduction in cost are achieved.

In the first embodiment, a method of thermal radiation of the luminaire 1 is also provided in addition to the luminaire 1.

The method of thermal radiation of the luminaire is a method of radiating the heat generated by the electronic components 40 from the second main surface 30b to the first main surface 30a of the circuit board 30 via the thermally-conductive medium 50 disposed in the notch 31 or the through hole 32 in contact with the electronic components 40.

In the method of thermal radiation of the luminaire, the notch 31 or the through hole 32 is provided at the mount position of the electronic components 40 in the circuit board 30.

In the method of thermal radiation of the luminaire, the notch 31 or the through hole 32 is formed under the electronic components 40 in the circuit board 30.

In the method of thermal radiation of the luminaire, at least parts of the electronic components 40 may be inserted into the notch 31 or the through hole 32 of the circuit board 30.

In the method of thermal radiation of the luminaire, the outer frame member 60, which is configured to accommodate the light-emitting portion 20, the circuit board 30, the electronic components 40, and the thermally-conductive medium 50, is further provided, the thermally-conductive medium 50 and the outer frame member 60 are brought into contact with each other. As a result, the heat generated by the electronic components 40 is radiated to the outer frame member 60 and the thermal radiator 10 via the thermally-conductive medium 50.

In the method of thermal radiation of the luminaire, the heat generated by the electronic components 40 may be radiated to the portion of the thermal radiator from the outer frame member 60 via the thermally-conductive medium 50 by further using the thermal radiator 10 having the portion which is in contact with the outside of the outer frame member 60.

In the method of thermal radiation of the luminaire, the thermal radiator 10 may be fixed to the outer frame member 60 by a fixing member 90 (described later). In this case, the thermally-conductive medium 50 is brought into contact with the fixing member 90, and the heat generated by the electronic components 40 is radiated to the thermal radiator 10 via the thermally-conductive medium 50 and the fixing member 90. Also, at this time, a thermal radiation route from the fixing member 90 to the outer frame member 60 may be formed.

In the method of thermal radiation of the luminaire, the circuit pattern is provided on the first main surface 30a of the circuit board 30, the thermally-conductive medium 50 is brought into contact with the circuit pattern, and the heat generated by the electronic components 40 is transferred to the side of the first main surface 30a of the circuit board 30 via the thermally-conductive medium 50 and the circuit pattern.

In the method of thermal radiation of the luminaire, a configuration in which part of the thermal radiator 10 is inserted into the outer frame member 60 so as to penetrate through the outer frame member 60, and part of the thermal radiator 10 exposed inside of the outer frame member 60 is brought into contact with the thermally-conductive medium 50 is also applicable.

### (Second Embodiment)

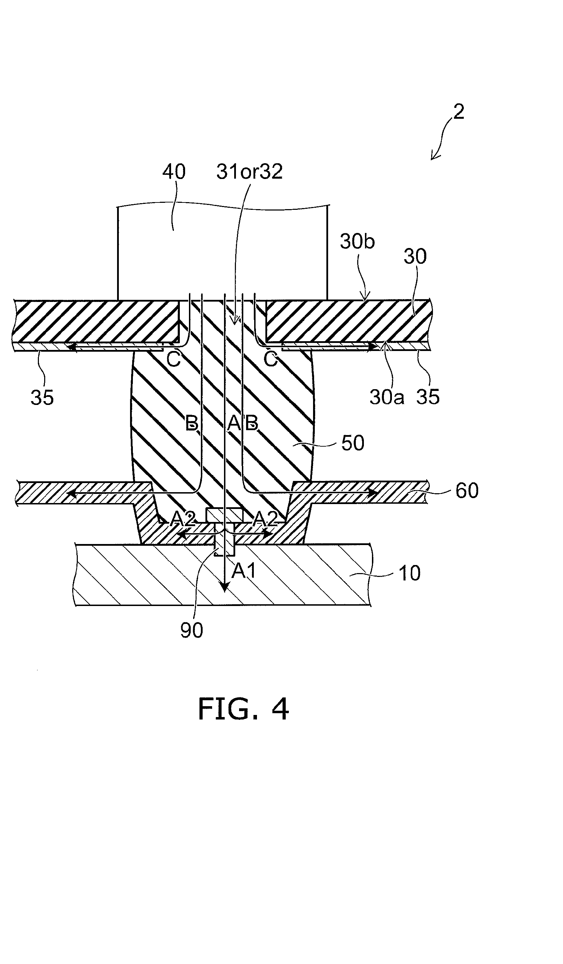

Fig. 4 is a schematic cross-sectional view of the luminaire according to a second embodiment.

In a luminaire 2 according to the second embodiment, the thermal radiator 10 is fixed to the outer frame member 60 via the fixing member 90, and the thermally-conductive medium 50 is in contact with the fixing member 90, the outer frame member 60, and the first main surface 30a of the circuit board 30. Examples of the fixing member 90 include a metallic screw, for example.

In the luminaire 2 as well, the heat generated by the electronic components 40 is radiated from the side of the second main surface 30b to the side of the first main surface 30a of the circuit board 30 via the thermally-conductive medium 50 disposed in the notch 31 or the through hole 32 in contact with the electronic components 40.

For example, in a route A in Fig. 4, the heat generated by the electronic components 40 is transferred from the side of the second main surface 30b to the side of the first main surface 30a of the circuit board 30 via the thermally-conductive medium 50 disposed in the notch 31 or the through hole 32 in contact with the electronic components 40. Subsequently, the heat is discharged to the thermal radiator 10 (arrow Al) and in addition is radiated to the outer frame member 60 (arrow A2) via the thermally-conductive medium 50 and the fixing member 90.

In a route B, the heat generated by the electronic components 40 is transferred from the side of the second main surface 30b to the side of the first main surface 30a of the circuit board 30 via the thermally-conductive medium 50 in contact with the electronic components 40 via the notch 31 or the through hole 32. Subsequently, the heat is radiated to the outer frame member 60 via the thermally-conductive medium 50.

In this manner, the heat generated by the electronic components 40 is radiated to the thermal radiator 10 and the outer frame member 60 efficiently via the thermally-conductive medium 50 and the fixing member 90.

Circuit patterns 35 are provided also on the side of the first main surface 30a of the circuit board 30. If the thermally-conductive medium 50 and the circuit pattern 35 are in contact to each other, the heat is transferred along a route C in the drawing.

In the route C, the heat generated by the electronic components 40 is transferred from the side of the second main surface 30b to the side of the first main surface 30a of the circuit board 30 via the thermally-conductive medium 50 filled in the notch 31 or the through hole 32. In other words, the heat generated by the electronic components 40 is radiated to the circuit pattern 35 on the side of the first main surface 30a via the thermally-conductive medium 50.

The heat generated by the electronic components 40 is efficiently dispersed along the route A, the route B, and the route C. In the luminaire 2, since the fixing member 90 is provided, the thermal conducting efficiency is further enhanced. Consequently, the thermal radiating effect of the electronic components 40 is further enhanced.

### (First Example of Third Embodiment)

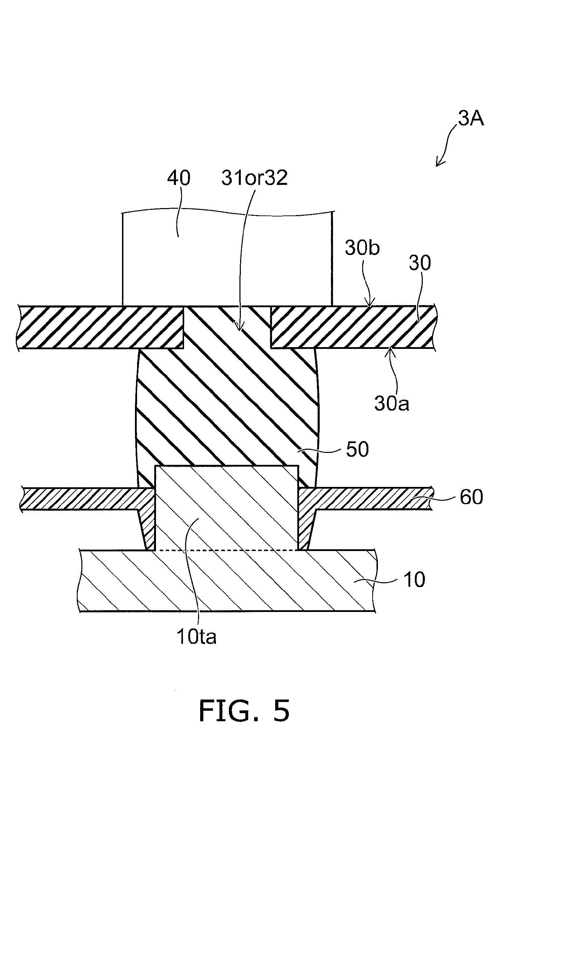

Fig. 5 is a schematic cross-sectional view of the luminaire according to a first example of a third embodiment.

Fig. 5 illustrates a state in which a portion near the thermally-conductive medium 50 of a luminaire 3A is enlarged.

In the luminaire 3A according to the third embodiment, part of the thermal radiator 10 exposed inside of the outer frame member 60 is in contact with the thermally-conductive medium 50. In Fig. 5, part of the thermal radiator 10 penetrates through the outer frame member 60, and the penetrated part of the thermal radiator 10 is illustrated as a projecting portion 10ta. The material of the projecting portion 10ta is, for example, aluminum.

In the luminaire 3A, since the projecting portion 10ta is in direct contact with the thermally-conductive medium 50, the heat generated by the electronic components 40 is transferred directly to the thermal radiator 10 via the thermally-conductive medium 50. Therefore, the thermal radiating effect of the electronic components 40 is further enhanced. Since the part of the thermal radiator 10 penetrates through the outer frame member 60 and gets closer to the circuit board 30, the amount of usage of the thermally-conductive medium 50 is further reduced correspondingly. Consequently, the manufacture of the luminaire at low cost is achieved.

### (Second Example of Third Embodiment)

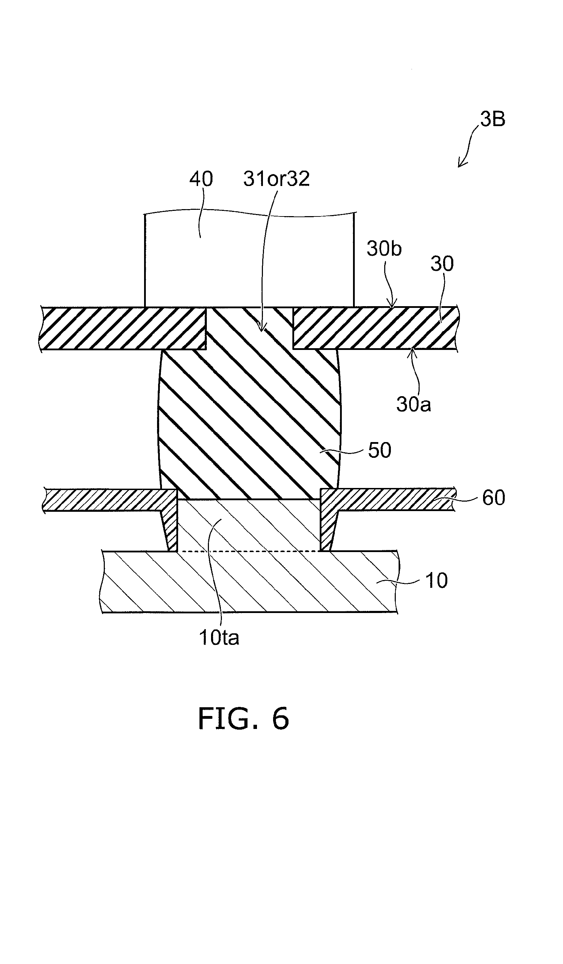

Fig. 6 is a schematic cross-sectional view of the luminaire according to a second example of the third embodiment.

In a luminaire 3B illustrated in Fig. 6, the projecting portion 10ta which is the projecting part of the thermal radiator 10 is provided. However, the projecting portion 10ta does not penetrate through the outer frame member 60.

By the projecting portion 10ta formed in this manner, the amount of usage of thermally-conductive medium may be reduced in comparison with the case where the thermal radiator 10 having a flat shape is thermally connected to the electronic components 40 via the thermally-conductive medium 50. The outer frame member 60 may be positioned with respect to the projecting portion 10ta. Here, the notch 31 or the through hole 32 is arranged so as to oppose the thermal radiator 10 on the inside of an outer periphery of the thermal radiator 10 and the projecting portion 10ta is arranged so as to oppose the notch 31 or the through hole 32. In other words, the notch 31 or the through hole 32 is provided immediately below the electronic components 40, and the projecting portion 10ta is provided immediately below the notch 31 or the through hole 32. Accordingly, the amount of usage of the thermally-conductive medium 50 is reduced.

### (Fourth Embodiment)

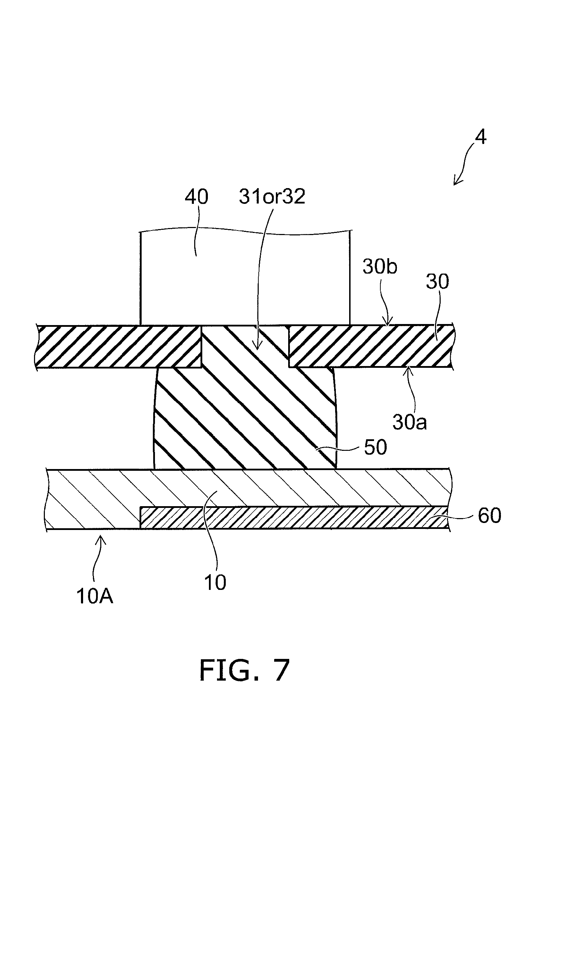

Fig. 7 is a schematic cross-sectional view of the luminaire according to a fourth embodiment.

In a luminaire 4 according to the fourth embodiment, at least part of the thermal radiator 10 is provided on the inside of the outer frame member 60. Then, the thermally-conductive medium 50 is in contact with the thermal radiator 10 in the interior of the outer frame member 60.

The heat generated by the electronic components 40 is transferred to the thermal radiator 10 via the thermally-conductive medium 50 in contact with the electronic components 40 via the interior of the notch 31 or the through hole 32. In this manner, the thermal radiation from the electronic components 40 may be accelerated.

As shown in Fig. 7, if part 10A of the thermal radiator 10 is exposed to the outside of the outer frame member 60, the thermal radiating efficiency is further enhanced. However, the fourth embodiment is not limited to the configuration in which part of the thermal radiator is exposed to the outside as described above, and a configuration in which the entire part of the thermal radiator 10 is provided in the interior of the outer frame member 60 is also applicable.

According to the fourth embodiment, for example, if the thermal radiator 10 is formed of a metal such as aluminum and the outer frame member 60 is formed of a resin, the heat transferred from the electronic components 40 via the thermally-conductive medium 50 may be transferred to the thermal radiator 10 having a coefficient of thermal conductivity higher than the coefficient of thermal conductivity of the resin, so that the efficient thermal radiation is achieved.

### (Fifth Embodiment)

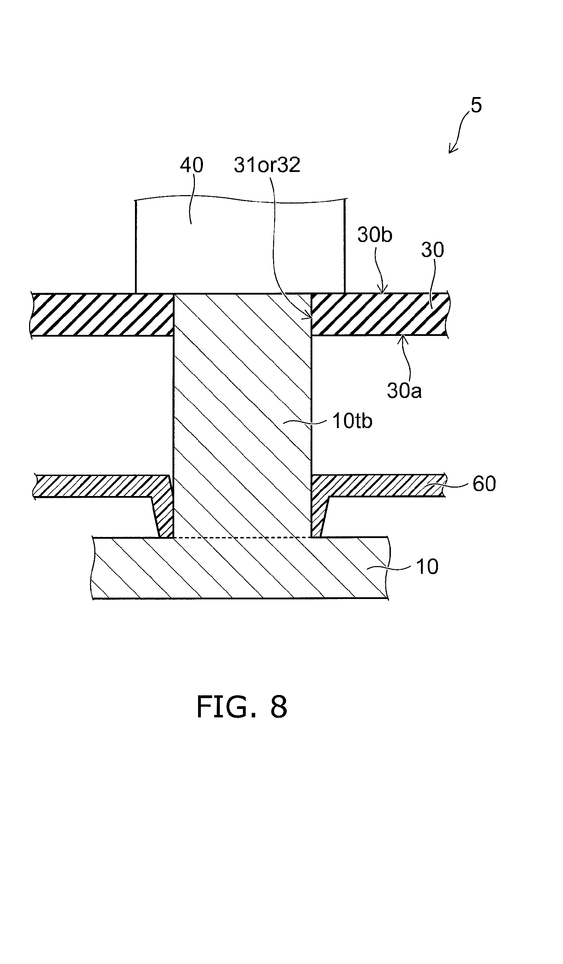

Fig. 8 is a schematic cross-sectional view of the luminaire according to a fifth embodiment.

In a luminaire 5 according to the fifth embodiment, part of the thermal radiator 10 extending from the thermal radiator 10 is inserted into the notch 31 or the through hole 32, and the corresponding part of the thermal radiator and the electronic components 40 are in contact with each other. Fig. 8 illustrates the extending part of the thermal radiator 10 as a projecting portion 10tb. The material of the projecting portion 10tb is, for example, aluminum.

In the luminaire 5, the heat generated by the electronic components 40 is transferred from the side of the second main surface 30b to the side of the first main surface 30a of the circuit board 30 via the part (projecting portion 10tb) of the thermal radiator inserted into the notch 31 or the through hole 32. In the luminaire 4, since the projecting portion 10tb is in direct contact with the electronic components 40, the heat generated by the electronic components 40 is directly radiated to the thermal radiator 10 via the projecting portion 10tb of the thermal radiator 10. Therefore, the thermal radiating effect of the electronic components 40 is further enhanced. Also, since the thermally-conductive medium 50 is not used, the manufacture of the luminaire is achieved at low cost correspondingly.

### (Sixth Embodiment)

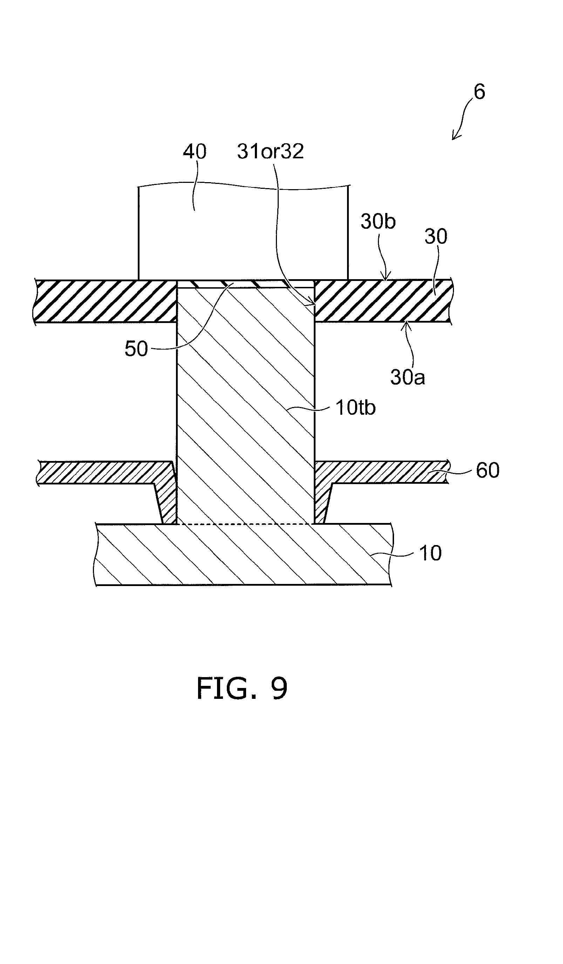

Fig. 9 is a schematic cross-sectional view of the luminaire according to a sixth embodiment.

In a luminaire 6 according to the sixth embodiment, the part of the thermal radiator 10 extending from the thermal radiator 10 is inserted into the notch 31 or the through hole 32 in the same manner as the fifth embodiment.

In the sixth embodiment, the thermally-conductive medium 50 is interposed between the thermal radiator 10 and the electronic components 40. In this configuration, thermal contact between the thermal radiator 10 and the electronic components 40 is improved, and hence transfer of the heat to the thermal radiator 10 is accelerated.

In the sixth embodiment, even when the thickness of the thermally-conductive medium 50 is decreased, the thermal contact between the thermal radiator 10 and the electronic components 40 may be maintained desirably. In other words, the desirable thermal radiation is realized while using a small amount of the thermally-conductive medium 50.

### (Seventh Embodiment)

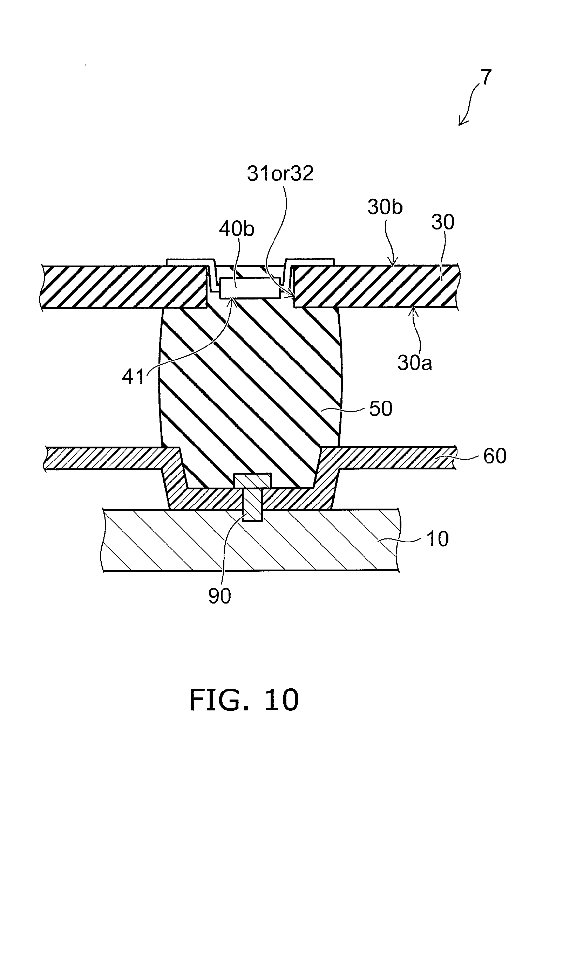

Fig. 10 is a schematic cross-sectional view of the luminaire according to a seventh embodiment.

In a luminaire 7 according to the seventh embodiment, at least part of the electronic components 40 (the electronic component 40b) is inserted into the notch 31 or the through hole 32 of the circuit board 30.

In the luminaire 7, since at least the part of the electronic component 40b is inserted into the notch 31 or in the through hole 32, the electronic component 40b gets closer to the thermal radiator 10 correspondingly. Therefore, the thermal radiating effect of the electronic components 40 is further enhanced.

In Fig. 10, a state in which the electronic component 40b is embedded into the thermally-conductive medium 50 is illustrated. However, a configuration in which the electronic component 40b is not embedded into the thermally-conductive medium 50 and an upper surface of the thermally-conductive medium 50 is brought into contact with a lower surface 41 of the electronic component 40b is also applicable.

### (Eighth Embodiment)

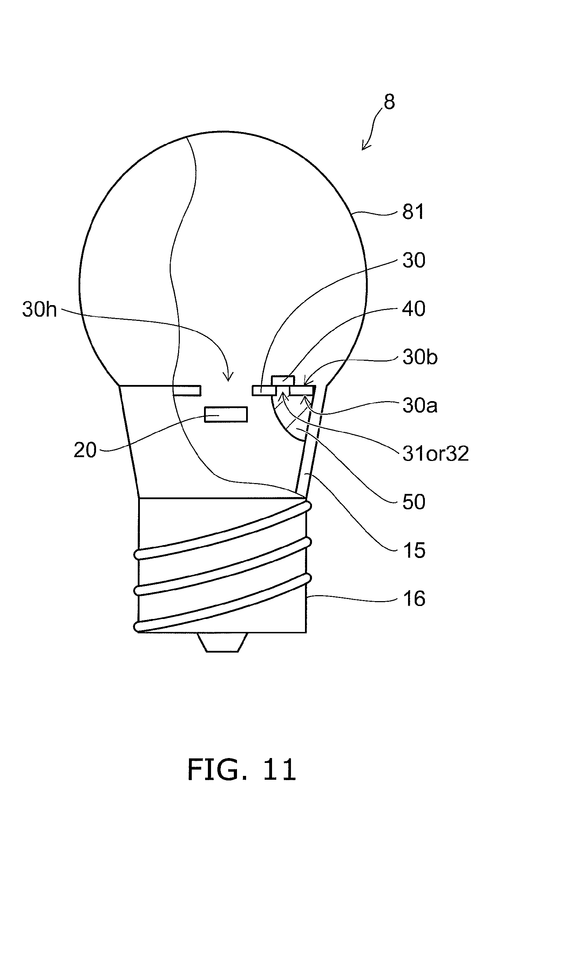

Fig. 11 is a schematic partial cross-sectional view of the luminaire according to an eighth embodiment.

A luminaire 8 according to the eighth embodiment is a luminaire having a bulb shape.

The luminaire 8 includes the light-emitting portion 20, the thermal radiator 15 configured to radiate heat generated by the light-emitting portion 20 to the outside, and the circuit board 30. The material of the thermal radiator 15 is, for example, aluminum (Al). The thermal radiator 15 also functions as an outer frame member of the luminaire. The circuit board 30 includes the notch 31 or the through hole 32. The circuit board 30 is provided above the thermal radiator 15 at a predetermined distance from the thermal radiator 15 and the light-emitting portion 20, that is, on the side of the light-emitting of the light-emitting portion 20.

The luminaire 8 also includes the electronic components 40. The electronic components 40 is mounted on the side of the second main surface 30b of the circuit board 30 opposite to the first main surface 30a of the circuit board 30. The luminaire 8 further includes the thermally-conductive medium 50. The thermally-conductive medium 50 is provided on the side of the first main surface 30a of the circuit board 30, and is in contact with the electronic component 40 via the notch 31 or the through hole 32. In addition, the luminaire 8 includes a translucent shielding member 81 having a spherical shape and a cap 16.

In the luminaire 8, the heat generated by the electronic components 40 is transferred from the side of the second main surface 30b to the side of the first main surface 30a of the circuit board 30 via the thermally-conductive medium 50 in contact with the electronic components 40 via the interior of the notch 31 or the interior of the through hole 32. Subsequently, the heat is radiated to the thermal radiator 15 or the cap 16 via the thermally-conductive medium 50. Therefore, in the luminaire 8 as well, the thermal radiating effect of the electronic components 40 is enhanced.

Also, the luminaire 8 does not require covering of the entire surfaces of the electronic components 40 on the side of the second main surface 30b of the circuit board 30 with the thermally-conductive medium 50, or embedding the electronic components 40 into the thermally-conductive medium 50. Therefore, the amount of usage of the thermally-conductive medium 50 is significantly reduced, so that the cost reduction of the luminaire is achieved.

The embodiments are described with reference to detailed examples thus far. However, the embodiments are not limited to the detailed examples shown above. In other words, configurations modified in design as needed by those skilled in the art are also included within the scope of the embodiments as long as characteristics of the embodiments are included. The respective elements provided in respective detailed examples, the arrangements, the materials, the conditions, the shapes and the sizes thereof are not limited to the examples given above, and modifications may be made as needed.

The respective elements provided in the above-described embodiments may be combined as long as technically possible, and such combined configurations are also included in the scope of the embodiments as long as the characteristics of the embodiments are included. Various modifications or corrections may be imagined by those skilled in the art within the range of the consciousness of the embodiments, and those modifications and corrections are also understood to be included in the scope of the embodiments.

Although the several exemplary embodiments are described thus far, these embodiments are illustrative only, and are not intended to limit the scope of the invention. The novel embodiments as described above may be implemented in various modes, and omissions, replacements, and modifications may be made without departing the scope of the exemplary embodiments. These embodiments and the modifications are included in the scope and the gist of the exemplary embodiments, and are included in claims and equivalent ranges.

## Claims

1. A luminaire comprising:
a light-emitting portion (20) having a light-emitting element;
a circuit board (30) having a notch (31) or a through hole (32);
an electronic component (40) mounted on a side of a second main surface (30b) opposite to a first main surface (30a) of the circuit board (30);
a thermal radiator (10) provided on a side of the first main surface (30a) and including the light-emitting portion (20) disposed on the thermal radiator (10);
a thermally-conductive medium (50) disposed on the side of the first main surface (30a) of the circuit board (30) and being in contact with the electronic component (40) through the notch (31) or the through hole (32), and capable of transferring heat generated by the electronic component (40) to the side of the first main surface (30a) of the circuit board (30); and
an outer frame member (60) accommodating the light-emitting portion (20), the circuit board (30), the electronic component (40), and the thermally-conductive medium (50).

2. The luminaire according to claim 1, wherein the circuit board (30) includes the notch (31) or the through hole (32) at a mount position of the electronic component (40).

3. The luminaire according to claim 1 or 2, wherein at least part of the electronic component (40) is inserted into the interior of the notch (31) or the interior of the through hole (32) of the circuit board (30).

4. The luminaire according to any one of claims 1-3, wherein the thermally-conductive medium (50) is contact with the outer frame member (60), and
the heat generated by the electronic component (40) is transferred to the outer frame member (60) via the thermally-conductive medium (50).

5. The luminaire according to any one of claims 1-4, wherein the thermal radiator (10) includes portion contacting with the outer frame member (60), and
the heat generated by the electronic component (40) is transferred to the portion of the thermal radiator (10) via the thermally-conductive medium (50) and the outer frame member (60).

6. The luminaire according to any one of claims 1-5, further comprising a fixing member (90) fixing the thermal radiator (10) and the outer frame member (60), wherein
the thermally-conductive medium (50) is contact with the fixing member (90), and
the heat generated by the electronic component (40) is transferred to the thermal radiator (10) via the thermally-conductive medium (50) and the fixing member (90).

7. The luminaire according to any one of claims 1-6, wherein a circuit pattern (35) is provided on the first main surface (30a) of the circuit board (30),
the thermally-conductive medium (50) is contact with the circuit pattern (35), and
the heat generated by the electronic component (40) is transferred to the side of the first main surface (30a) of the circuit board (30) via the thermally-conductive medium (50) and the circuit pattern (35).

8. The luminaire according to any one of claims 1-7, wherein the thermal radiator (10) includes a projecting portion (10ta) arranged so as to be partly exposed to the inside of the outer frame member (60), and
the projecting portion (10ta) is in contact with the thermally-conducive medium.

9. The luminaire according to any one of claims 1-7, wherein at least part of the thermal radiator (10) is provided in the interior of the outer frame member (60), and
the thermally-conductive medium (50) is in contact with the thermal radiator (10) in the interior of the outer frame member (60).

10. The luminaire according to claim 8, wherein the projecting portion (10ta) of the thermal radiator (10) is inserted into the notch (31) or the through hole (32), and
the heat generated by the electronic component (40) is transferred from the side of the second main surface (30b) to the side of the first main surface (30a) of the circuit board (30) via the projecting portion (10ta) inserted into the notch (31) or the through hole (32).

11. A method of thermal radiation of a luminaire including:
a light-emitting portion (20) having a light-emitting element;
a circuit board (30) having a notch (31) or a through hole (32);
an electronic component (40) mounted on a side of a second main surface (30b) opposite to a first main surface (30a) of the circuit board (30);
a thermal radiator (10) provided on a side of the first main surface (30a) and including the light-emitting portion (20) disposed on the thermal radiator (10);
a thermally-conductive medium (50) disposed on the side of the first main surface (30a) of the circuit board (30) and being in contact with the electronic component (40) through the notch (31) or the through hole (32); and
an outer frame member (60) accommodating the light-emitting portion (20), the circuit board (30), the electronic component (40), and the thermally-conductive medium (50), comprising:
transferring heat generated by the electronic component (40) to the side of the first main surface (30a) of the circuit board (30) via the thermally-conductive medium (50).

12. The method according to claim 11, comprising:
providing the notch (31) or the through hole (32) at a mount position of the electronic component (40) in the circuit board (30).

13. The method according to claim 11 or 12, comprising:
inserting at least part of the electronic component (40) into the interior of the notch (31) or the interior of the through hole (32) of the circuit board (30).

14. The method according to any one of claims 11-13, comprising:
contacting the thermally-conductive medium (50) with the outer frame member (60) ; and
transferring the heat generated by the electronic component (40) to the outer frame member (60) via the thermally-conductive medium (50).

15. The method according to any one of claims 11-14, comprising:
providing the thermal radiator (10) with a portion contacted with the outside of the outer frame member (60); and
transferring the heat generated by the electronic component (40) to the portion of the thermal radiator (10) via the thermally-conductive medium (50) and the outer frame member (60).
